Europäisches Patentamt

European Patent Office

Office européen des brevets

(11) Veröffentlichungsnummer : **0 022 992**
**B1**

(12) # EUROPÄISCHE PATENTSCHRIFT

(45) Veröffentlichungstag der Patentschrift :
20.04.83

(51) Int. Cl.³ : **G 01 R 31/02**, **H 02 H 7/16**

(21) Anmeldenummer : **80103990.0**

(22) Anmeldetag : **10.07.80**

(54) **Überwachungseinrichtung für die Kondensatorbatterie eines Gleichstromfilterkreises.**

(30) Priorität : **24.07.79 DE 2930034**

(43) Veröffentlichungstag der Anmeldung :
**28.01.81 Patentblatt 81/04**

(45) Bekanntmachung des Hinweises auf die Patenterteilung : **20.04.83 Patentblatt 83/16**

(84) Benannte Vertragsstaaten :
**DE GB SE**

(56) Entgegenhaltungen :
**DE B 2 451 353**
**DE B 2 807 095**
**US A 3 319 120**

(73) Patentinhaber : **SIEMENS AKTIENGESELLSCHAFT**
**Berlin und München Wittelsbacherplatz 2**
**D-8000 München 2 (DE)**

(72) Erfinder : **Becker, Michael, Dipl.-Ing.**
**Ringstrasse 50**
**D-8521 Uttenreuth (DE)**
Erfinder : **Renz, Klaus, Dipl.-Ing.**
**Heinrich-Heine-Strasse 15**
**D-8510 Fürth (DE)**
Erfinder : **Weibelzahl, Manfred, Dipl.-Ing.**
**Eichenweg 10**
**D-8521 Weiher (DE)**

Jouve, 18, rue St-Denis, 75001 Paris, France

Überwachungseinrichtung für die Kondensatorbatterie eines Gleichstrom-Filterkreises

Die Erfindung bezieht sich auf eine Überwachungseinrichtung für die Kondensatorbatterie eines Gleichstrom-Filterkreises, die aus wenigstens zwei gleich aufgebauten parallelen Strängen mit jeweils einer Anzahl von in Reihe geschalteten Kondensatoren besteht, wobei aus den Sekundärspannungen von in den Strängen angeordneter Stromwandler eine der Differenz der Strangströme entsprechende Größe gebildet wird.

Eine solche Überwachungseinrichtung ist gemäß dem Dokument DE-B-2 451 353 bekannt. Die Auswertung der Differenz der Stromwandler-Sekundärspannungen erfolgt dort mittels zweier Differentialschutzrelais, von denen das eine nur bei hochfrequent auftretenden Unsymmetrien in den Strängen und das andere nur bei niederfrequent auftretenden Unsymmetrien in den Strängen anspricht. Die bekannte Überwachungseinrichtung läßt sich zwar damit gegenüber langsam verlaufenden Ausgleichsvorgängen, wie sie beispielsweise bei unterschiedlicher Wirkung von Umgebungseinflüssen auf die einzelnen Stränge auftreten, unempfindlich machen, es gibt jedoch auch betriebsbedingte, schnell verlaufende Unsymmetrien, welche beispielsweise bei Änderungen des Zündwinkels des Gleichrichters entstehen können, welche die Überwachungseinrichtung ebenfalls nicht zum Ansprechen bringen sollten.

Der Erfindung liegt die Aufgabe zugrunde, eine Überwachungseinrichtung der eingangs genannten Art zu schaffen, welche auf einfache Weise den Ausfall eines oder mehrerer Kondensatoren zuverlässig anzeigt, d. h. nur bei nicht betriebsbedingten Unsymmetrien zum Ansprechen gelangt.

Diese Aufgabe wird erfindungsgemäß durch folgende Merkmale gelöst :

a) Die Summe und die Differenz der Stromwandler-Sekundärspannungen in jeweils zwei gleich aufgebauten Strängen wird mittels je einer Gleichrichterschaltung und einem dieser nachgeordneten Tiefpaßfilter in zwei Gleichspannungen umgeformt, deren Amplitude der Differenz bzw. der Summe der Oberschwingungsströme in den beiden Strängen proportional sind ;

b) mittels Vergleichsglieder wird die Differenzspannung zwischen der dem Oberschwingungs-Differenzstrom proportionalen Gleichspannung und einem jeweils dem einzelnen Vergleichsglied zugeordneten Bruchteil der dem Oberschwingungs-Summenstrom proportionalen Gleichspannung gebildet und diese Differenzspannungen werden jeweils einem Grenzwertmelder zugeführt, dem jeweils ein Zeitglied mit Ansprechverzögerung nachgeschaltet ist ;

c) die Ausgangssignale der Vergleichsglieder und die Ausgangssignale der Zeitglieder werden jeweils den Eingängen von Summiergliedern zugeführt, deren Ausgangssignale mit den Eingängen eines im Eingang einer Auswertestufe angeordneten Vergleichsgliedes verbunden sind, welches die Differenz zwischen den Ausgangssignalen der Summierglieder bildet.

Die erfindungsgemäße Überwachungseinrichtung geht davon aus, daß sich bei dem Ausfall eines Kondensators in der Kondensatorbatterie zwar der Oberschwingungs-Gesamtstrom nicht in meßtechnisch auswertbarer Weise ändert, daß sich jedoch die Stromaufteilung auf die einzelnen Stränge meßbar ändert. Es wird daher die Stromdifferenz zwischen zwei Strängen oder Gruppen von Strängen erfaßt. Damit die Überwachungseinrichtung nicht bei Änderungen der Oberschwingungsströme anspricht, die durch Änderungen des Zündwinkels des Gleichrichters hervorgerufen werden, wird die genannte Stromdifferenz auf den Gesamtstrom bezogen. Nur wenn sich die Stromdifferenz zwischen den Oberschwingungsströmen in jeweils gleich aufgebauten Strängen oder Gruppen von parallelgeschalteten Strängen ändert, ohne daß sich gleichzeitig auch der Gesamtstrom im gleichen Maße und im gleichen Sinne ändert, sprechen die Grenzwertmelder an. Damit die Überwachungseinrichtung nicht bei Änderungen des Gesamtstromes oder der Stromdifferenz anspricht, die beispielsweise durch die Temperaturabhängigkeit des Gleichstromwiderstandes der Kondensatoren hervorgerufen werden, sind den Grenzwertmeldern Zeitglieder mit Ansprechverzögerung nachgeschaltet. Die summierten Ausgangssignale der Grenzwertmelder der Zeitglieder werden miteinander verglichen und das Vergleichsergebnis wird ausgewertet. Ändert sich das Vergleichsergebnis nur wenig, so erfolgt keine Störungsanzeige. Ändert sich das Vergleichsergebnis dagegen stark, so wird ein entsprechendes Störungssignal abgegeben. Nach Ablauf der Ansprechverzögerung der Zeitglieder kann die erfindungsgemäße Überwachungseinrichtung den nächsten Störungsfall erkennen und anzeigen.

Ein Ausführungsbeispiel der Erfindung ist in den Zeichnungen dargestellt und wird im folgenden näher beschrieben. Es zeigen :

Figur 1 ein Blockschaltbild einer erfindungsgemäßen Überwachungseinrichtung,

Figur 2 ein Beispiel einer Auswerteschaltung 27,

Figur 3 ein Beispiel einer Auswerteeinrichtung 19,

Figur 4 ein weiteres Beispiel einer Auswerteschaltung 50,

Figur 5 ein Beispiel einer Bereichsumschaltung.

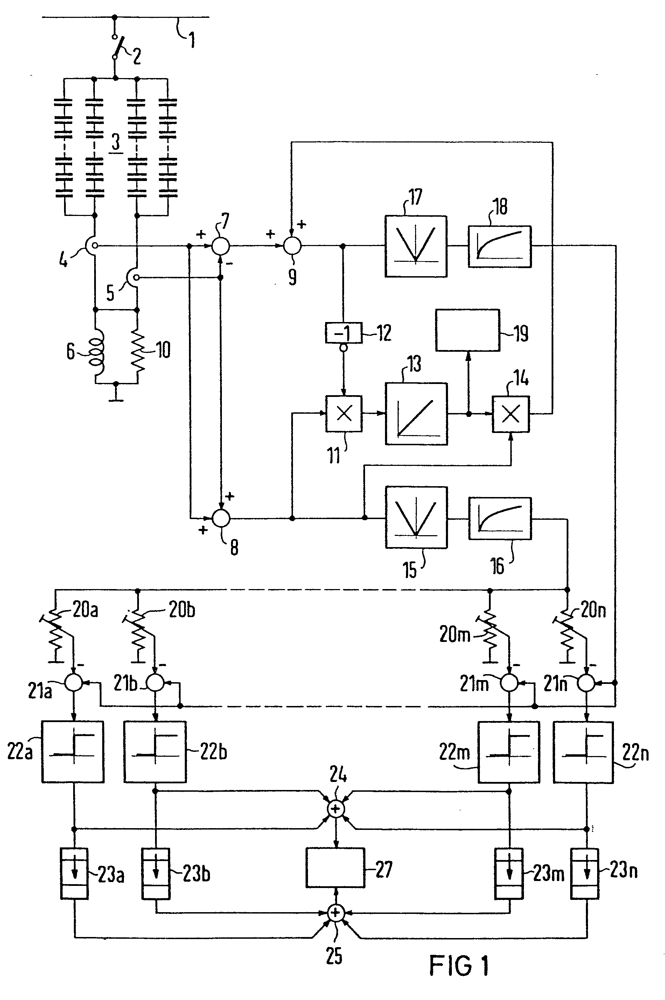

Fig. 1 zeigt den prinzipiellen Aufbau eines Ausführungsbeispiels einer erfindungsgemäßen Überwachungseinrichtung für die Kondensatorbatterie 3 eines Gleichstrom-Filterkreises, der über eine Schalteinrichtung 2 an eine Gleichstromleitung 1 angeschlossen ist, insbesondere an eine Hochspannungs-Gleichstrom-Übertragungsleitung. Der als Saugkreis ausgebildete Filterkreis besteht aus der Reihenschaltung einer Kondensatorbatterie 3 mit einer Drosselspule 6, der ein Widerstand 10 parallelgeschaltet sein kann. Die Kondensatorbatterie 3 besteht im Beispiel aus vier parallelen Strängen mit jeweils einer großen Anzahl, beispielsweise 20, in Reihe geschalteten Kondensatoren. Jeweils zwei Stränge sind zu einer Gruppe zusammengeschaltet, so daß beide Gruppen einen vollkommen symmetrischen Aufbau aufweisen. Beim Ausfall eines Kondensators wird zwar der Filterkreis etwas verstimmt, er bleibt jedoch noch funktionsfähig. Der Ausfall eines Kondensators wird daher nur angezeigt, damit der Defekt bei einer passenden Gelegenheit beseitigt werden kann, beispielsweise bei der routinemäßigen Wartung. Die Überwachungseinrichtung soll jedoch möglichst rasch bereit sein, den Ausfall eines weiteren Kondensators zu erkennen. Beim Ausfall zweier Kondensatoren wird der Filterkreis so verstimmt, daß möglichst rasch eine Instandsetzung vorgenommen werden muß. Es ist jedoch noch keine sofortige Notabschaltung erforderlich. Erst wenn ein weiterer Kondensator ausfällt, was die Überwachungseinrichtung wiederum zuverlässig erfassen soll, muß der Filterkreis über die Schalteinrichtung 2 unverzüglich von der Leitung 1 getrennt werden.

Die erfindungsgemäße Überwachungseinrichtung soll also jeweils zuverlässig ermitteln, wie viele der Kondensatoren nacheinander ausgefallen sind. Andererseits sollen durch den Temperaturgang der Kondensatoren, der größere Stromänderungen verursachen kann als der Ausfall eines Kondensators, keine Fehlmeldungen erfolgen.

Die Oberschwingungsströme durch jede der beiden Gruppen von Strängen werden mit induktiven Stromwandlern 4 bzw. 5 gemessen, die keine Gleichstromkomponenten erfassen. Die an den (nicht dargestellten) Bürden der beiden Stromwandler 4 und 5 abfallenden Meßspannungen sind somit den Oberschwingungsströmen durch die jeweilige Hälfte der Kondensatorbatterie proportional.

Die Meßspannung für den Differenzstrom zwischen den beiden Hälften der Kondensatorbatterie 3 wird in einem Vergleichsglied 7 gebildet, dem die Ausgangssignale der beiden Stromwandler 4 und 5 mit unterschiedlichen Vorzeichen zugeführt sind. Die Meßspannung für den Oberschwingungs-Summenstrom durch die gesamte Kondensatorbatterie wird in einem Summierglied 8 gebildet, dem die Ausgangssignale der beiden Stromwandler 4 und 5 mit gleichem Vorzeichen zugeführt sind. In der praktischen Realisierung sind potentialtrennende Stromwandler eingesetzt, wobei die Differenz- bzw. Summenbildung durch entsprechende sekundärseitige Verschaltung erfolgt.

Für die Meßspannung, die den Differenzstrom zwischen den beiden Hälften der Kondensatorbatterie abbildet, ist eine Driftkompensation vorgesehen. Hierdurch werden einerseits die Auswirkungen von geringen Differenzströmen kompensiert, die beispielsweise durch unterschiedliche Temperaturen der beiden Batteriehälften auftreten können. Andererseits wird nach dem Ausfall eines Kondensators die dann ständig erfaßte Meßspannung für den Differenzstrom kompensiert, damit der Ausfall eines weiteren Kondensators erkannt werden kann.

Die Driftkompensation umfaßt ein Mischglied 9, sowie einen nichtlinearen Regelkreis mit einem integralen Regler 13, dem ausgangsseitig ein Multiplizierer 14 nachgeschaltet und eingangsseitig ein weiterer Multiplizierer 11 vorgeschaltet ist. Die Eingänge des weiteren Multiplizierers 11 sind über ein Invertierglied 12 mit dem Ausgangssignal des Mischgliedes 9 und mit der den Oberschwingungs-Summenstrom abbildenden Meßspannung vom Summierglied 8 beaufschlagt. Die Ausgangsspannung des weiteren Multiplizierers 11 hat jeweils diejenige Polarität, mit der die Meßspannung für den Differenzstrom korrigiert werden muß, da der Differenzstrom mit dem Summenstrom entweder in Phase liegt oder um 180° el phasenverschoben ist. Die Ausgangsspannung des Multiplizierers 11 wird dem integralen Regler 13 zugeführt, dessen Integrationszeitkonstante relativ groß eingestellt ist, beispielsweise in der Größenordnung von Sekunden.

Die Ausgangsgleichspannung des integralen Reglers 13 wird dem einen Eingang des nachgeschalteten Multiplizierers 14 zugeführt, dessen zweiter Eingang mit der den Oberschwingungs-Summenstrom abbildenden Meßspannung des Summiergliedes 8 beaufschlagt ist. Die Ausgangsspannung des Multiplizierers 14 ist somit die Meßspannung für den Oberschwingungs-Summenstrom, multipliziert mit einem durch die Reglerausgangsspannung bestimmten Faktor und mit einer Polarität, mit der die Meßspannung für den Differenzstrom auf Null gebracht werden kann. Die Ausgangsspannung des Multiplizierers 14 wird daher im Mischglied 9 als Korrekturspannung zur Meßspannung für den Differenzstrom hinzugefügt.

Zur Erläuterung der Funktionsweise dieser nichtlinearen Driftkompensation wird zunächst davon ausgegangen, daß der Oberschwingungs-Summenstrom durch den Filterkreis einen endlichen Wert aufweist, der Differenzstrom jedoch Null ist. An den Eingängen des Mischgliedes 9 liegt zunächst die den Wert Null abbildende Ausgangsspannung des Differenzgliedes 7 und die ebenfalls den Wert Null abbildende Ausgangsspannung des Multiplizierers 14 an. Das Ausgangssignal des Mischgliedes 9 hat daher ebenfalls den Wert Null. Entsteht ein Differenzstrom zwischen den beiden Hälften der Kondensatorbatterie 3, so erscheint am Ausgang des Summierers 7 und damit auch am Mischglied 9 eine von Null verschiedene Spannung, die über den Inverter 12 dem einen Eingang des weiteren Multiplizierers 11 zugeführt wird. Der Multiplizierer 11 bewertet die den Oberschwingungs-Summenstrom abbildende Spannung mit dem zur Kompensation erforderlichen Vorzeichen und führt sie dem Integralregler 13 zu. Die Ausgangsgleichspannung des Integralreglers 13 steigt nach Maßgabe der Integrationszeitkonstanten an. Damit erhält der Multiplizierer 14 an seinem mit dem Integralregler 13 verbundenen Eingang ebenfalls eine von Null verschiedene Spannung. Der Multiplizierer 14 multipliziert die den Oberschwingungs-Summenstrom abbildenden Ausgangsspannung des Summierers 8 mit einem durch die Ausgangsspannung des Integralreglers 13 bestimmten Faktor. Die Ausgangsspannung des Multiplizierers 14 wird auf das Mischglied 9 zurückgeführt. Der Integralregler 13 integriert solange, wie an seinem Eingang und damit aber auch am Ausgang des Differenzgliedes 7 ein von Null verschiedener Wert ansteht. Damit regelt der Integralregler 13 die den Differenzstrom abbildende Ausgangsspannung des Differenzgliedes 7 langsam auf Null aus. Die Ausgangsspannung des Integralreglers 13 und damit auch die Ausgangsspannung des Multiplizierers 14 behalten anschließend ihre Werte bei, bis sich die den Differenzstrom abbildende Meßspannung erneut ändert.

Die Ausgangsspannung des Integralreglers 13 ist ein Maß für die Unsymmetrie zwischen den beiden Hälften der Kondensatorbatterie 3. Die Ausgangsspannung des Integralreglers 13 wird daher einer Auswerteeinrichtung 19 zugeführt, die später im einzelnen beschrieben wird.

Die den Oberschwingungs-Summenstrom abbildende Ausgangsspannung des Summierers 8 wird auf eine Vollweggleichrichterbrücke 15 gegeben, der ein Tiefpaß 16 von erster Ordnung nachgeschaltet ist. Die Ausgangsspannung des Tiefpasses 16 ist somit eine amplitudenproportionale Gleichgröße, die den Summenstrom abbildet.

Die Ausgangsspannung des Mischgliedes 9, die — solange der langsame Integralregler 13 noch nicht eingegriffen hat — mit der Ausgangsspannung des Differenzgliedes 7 übereinstimmt und damit eine Meßspannung für den Differenzstrom ist, wird in einer weiteren Vollweggleichrichterbrücke 17 gleichgerichtet und ebenfalls über ein Tiefpaßfilter 18 von erster Ordnung geführt. Die Glättungs-Zeitkonstante des Tiefpaßfilters 16 entspricht der Glättungs-Zeitkonstante des Tiefpaßfilters 18. Die Ausgangsspannung des Tiefpaßfilters 18 ist eine amplitudenproportionale Gleichspannung, die den Differenzstrom zwischen den beiden Hälften der Kondensatorbatterie abbildet, solange der Integralregler 13 noch nicht eingegriffen hat.

Die amplitudenproportionalen Gleichgrößen für den Summenstrom und den Differenzstrom werden in einer Anzahl von Auswertestufen miteinander in Beziehung gesetzt. Die Auswertestufen enthalten Potentiometer 20a ... 20n, Vergleicher 21a ... 21n, Grenzwertmelder 22a ... 22n, Zeitglieder 23a ... 23n mit Ansprechverzögerung, Summierer 24, 25 und ein Vergleichsglied 26. Der Aufbau der gleichartig aufgebauten Auswertestufen wird anhand der ersten Auswertestufe erläutert, deren Elemente mit dem Index a gekennzeichnet sind.

Dem Vergleichsglied 21a der ersten Auswertestufe wird die dem Differenzstrom proportionale Ausgangsspannung des Tiefpaßfilters 18, sowie die um einen Faktor verringerte Ausgangsspannung des Tiefpaßfilters 16 zugeführt, die den Summenstrom abbildet. Der Faktor, um den der Summenstrom verkleinert wird, wird am Potentiometer 20a eingestellt. Die Ausgangsspannung des Vergleichsgliedes 21a wird auf einen Grenzwertmelder 22a gegeben. Dem Grenzwertmelder 22a ist ein Zeitglied 23a mit Ansprechverzögerung nachgeschaltet.

Die Potentiometer 20a ... 20n sind jeweils unterschiedlich eingestellt derart, daß in jeder Auswertestufe jeweils ein anderer Bruchteil des Summenstromes mit dem Differenzstrom verglichen wird. Je nach der Größe eines Differenzstromes wird somit einer oder mehrere Grenzwertmelder ansprechen, wenn der Differenzstrom — bevor ihn der Integralregler 13 kompensiert hat — einen bestimmten Bruchteil des Summenstromes übersteigt. Steht ein solcher Differenzstrom länger als die Ansprechverzögerung der nachgeschalteten Zeitglieder 23 an, so erzeugen auch diese ein entsprechendes Ausgangssignal. Die Ausgangssignale der Grenzwertmelder 22 und der Zeitglieder 23 sind auf gleiche Werte normiert. Die Ausgangsspannungen aller Grenzwertmelder 22a ... 22n werden in einem Summierglied 24 und die Ausgangsspannungen aller Zeitglieder 23 ... 23n werden in einem weiteren Summierglied 25 summiert. Die Ausgangsspannungen der Summierglieder 24 und 25 werden in einem Vergleicher 26 verglichen und die Differenz der Auswerteschaltung 27 zugeführt.

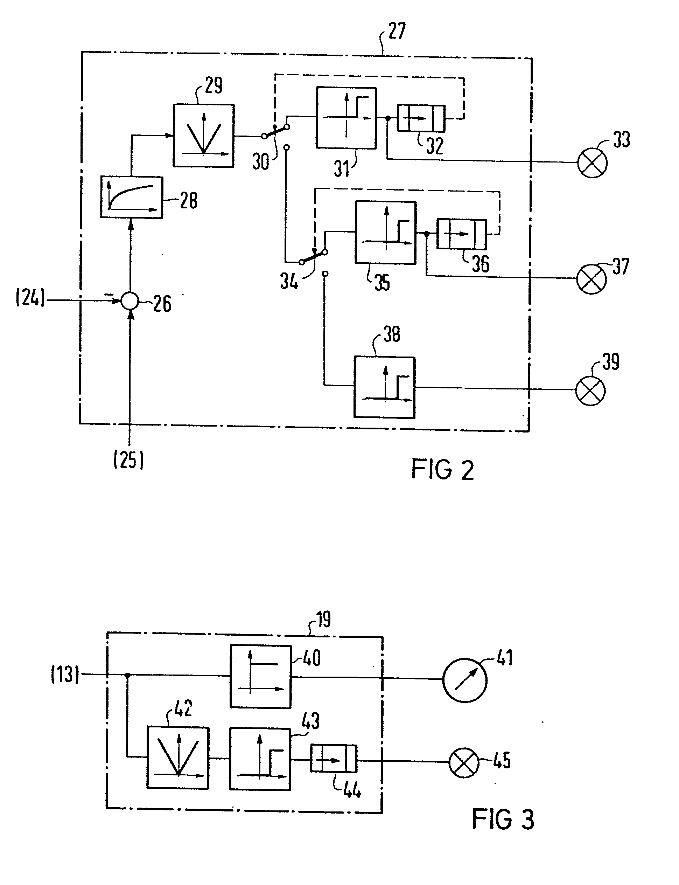

Fig. 2 zeigt den Aufbau der Auswerteeinrichtung 27. Die Eingangssignale sind das Summensignal der Grenzwertmelder 22a ... 22n vom Summierglied 24 und das Summensignal der Zeitstufen 23a ... 23n vom Summierglied 25. Das Summensignal des Summiergliedes 25 wird im Vergleicher 26 mit dem Summensignal des Summiergliedes 24 verglichen und das Vergleichsergebnis wird über ein Tiefpaßfilter 28 von 1. Ordnung geführt. Die Glättungszeitkonstante des Tiefpaßfilters 28 ist kleiner als die Ansprechverzögerung der Zeitglieder 23. Das Ausgangssignal des Tiefpaßfilters 28 wird zur Betragsbildung über eine Gleichrichterschaltung 29 und einen Umschalter 30 auf die erste Auswertestufe geführt.

Die erste Auswertestufe enthält einen Grenzwertmelder 31, dessen Ansprechschwellenwert so eingestellt ist, daß er erst dann ein Ausgangssignal abgibt, wenn die Differenz der Summensignale der Summierer 24 und 25 den n-fachen Wert der normierten Ausgangsspannung der Grenzwertmelder 22 bzw. Zeitglieder 23 übersteigt, beispielsweise wenn die genannte Differenz den dreifachen Wert der Ausgangsspannungen der Grenzwertmelder 22 bzw. Zeitglieder 23 übersteigt. Bleibt die genannte Differenz kleiner, so wird eine beispielsweise durch Temperatureinflüsse hervorgerufene Unsymmetrie der Kondensatorhälften angenommen. Übersteigt dagegen die genannte Differenz den Ansprechschwellenwert des Grenzwertmelders 31, so wird auf den Ausfall eines Kondensators geschlossen und das Signal des Grenzwertmelders 31 mit einer Anzeige 33 signalisiert und die Anzeige gespeichert. Das Signal des Grenzwertmelders 31 stößt eine Zeitstufe 32 mit Ansprechverzögerung an, die ihrerseits den Umschalter 30 umsteuert. Die Ansprechverzögerung der Zeitstufe 32 ist größer als die Ansprechverzögerung der Zeitglieder 23 und wird unter Berücksichtigung der Integrationszeitkonstante des integralen Reglers 13 gewählt.

Da das Differenzsignal zwischen den Summensignalen der Summierer 24 und 25 verschwindet, sobald die Zeitglieder 23 angesprochen haben, ist die Auswerteeinrichtung für den nächsten Kondensatorausfall vorbereitet. Das dabei erneut auftretende Differenzsignal wird über den umgesteuerten Umschalter 30 und den Umschalter 34 auf den Grenzwertmelder 35 gegeben. Spricht dieser an, so wird sein Ausgangssignal mit einer weiteren Anzeige 37 angezeigt und die Anzeige gespeichert. Gleichzeitig wird eine Zeitstufe 36 mit Ansprechverzögerung angestoßen, die ihrerseits den Umschalter 34 umsteuert.

Bei einem Ausfall eines weiteren Kondensators beaufschlagt das Differenzsignal über die umgesteuerten Umschalter 30 und 34 einen weiteren Grenzwertmelder 38, dessen Ausgangssignal mit einer weiteren Anzeige 39 angezeigt wird.

Es können anstelle der dargestellten drei Auswertestufen noch mehrere derartige Stufen vorgesehen sein. Die Ansprechschwellenwerte der Grenzwertmelder 31, 35, 38 sind vorzugsweise auf gleiche Werte eingestellt. Die Anzeige 33 bedeutet, daß ein Kondensator in der Kondensatorbatterie defekt ist. Der Siebkreis 3, 6, 10 kann noch weiter betrieben werden. Die Anzeige 37 bedeutet, daß zwei Kondensatoren defekt sind. Der Siebkreis muß zwar unverzüglich instandgesetzt werden, eine Notabschaltung ist jedoch nicht erforderlich. Der Siebkreis kann vielmehr bis zum Eintreffen des Wartungspersonals noch betrieben werden. Die Anzeige 39 bedeutet, daß drei Kondensatoren ausgefallen sind und eine sofortige Notabschaltung des Filterkreises erforderlich ist.

Fig. 3 zeigt den Aufbau der Auswerteeinrichtung 19. Der integrale Regler 13 liefert eine Ausgangsgleichspannung, die dem Grad der stationären Unsymmetrie zwischen den beiden Hälften der Kondensatorbatterie proportional ist. Die Ausgangsspannung des Integralreglers 13 wird daher über einen Anpaßverstärker 40 einem Mittelpunktsinstrument 41 zugeführt. Aus der Richtung des Zeigerausschlages läßt sich erkennen, in welcher Hälfte der defekte Kondensator ist, da die Polarität der Reglerausgangsspannung dadurch gegeben ist, ob der Summenstrom der beiden Batteriehälften mit dem Differenzstrom phasengleich oder um 180° el phasenverschoben ist.

Die Ausgangsgleichspannung des integralen Reglers 13 wird über eine Vollweggleichrichterschaltung 42 auf einen Grenzwertmelder 43 gegeben. Die Eingangsspannung des Grenzwertmelders 43 stellt somit ein Maß für die Unsymmetrie zwischen den beiden Batteriehälften dar, wobei eine positive oder negative Unsymmetrie gleich bewertet wird. Wenn die Eingangsspannung des Grenzwertmelders 43 seinen Ansprechschwellenwert, der auf einen vorgegebenen unerlaubten Unsymmetriegrad eingestellt ist, übersteigt, so wird ein nachgeschaltetes Zeitglied 44 mit Ansprechverzögerung angestoßen. Ist der unerlaubte Unsymmetriegrad, der beispielsweise dem Ausfall von drei Kondensatoren in einer Batteriehälfte entsprechen kann, nach Ablauf der Ansprechverzögerung noch vorhanden, so wird das Ausgangssignal des Zeitgliedes 44 mit der Anzeige 45 angezeigt und die Anzeige wird gespeichert.

Die gesamte Schaltung arbeitet wie folgt, wobei das Zahlenbeispiel willkürlich gewählt ist:

Im ungestörten Zustand treten kleinere Unsymmetrien zwischen den beiden Batteriehälften auf, die vom integralen Regler 13 ausgeregelt werden, ohne daß die nachgeschalteten Auswertestufen ansprechen. Bei größeren Unsymmetrien insbesondere aufgrund von Temperatureinflüssen kann es vorkommen, daß ein Grenzwertmelder 22a oder daß die Grenzwertmelder 22a und 22b ansprechen. Es entsteht am Vergleicher 26 ein Differenzsignal, das jedoch den Ansprechschwellenwert des Grenzwertmelders 31 nicht erreicht. Sobald die Zeitglieder 23 angesprochen haben, verschwindet das Differenzsignal. Der integrale Regler 13 regelt die den Differenzstrom abbildende Spannung auf Null.

Beim Ausfall eines Kondensators in der Kondensatorbatterie 3 sprechen mindestens drei der Grenzwertmelder 22 an. Der Grenzwertmelder 31 spricht ebenfalls an und betätigt die Anzeige 33. Nach Ablauf ihrer Ansprechverzögerung sprechen die Zeitglieder 23 an. Das Differenzsignal am Ausgang des Vergleichers 26 verschwindet. Der Regler 13 regelt die den Differenzstrom abbildende Spannung auf Null.

Beim Ausfall eines weiteren Kondensators sprechen wiederum wenigstens drei der Grenzwertmelder 22 und der Grenzwertmelder 35 an. Beim Ausfall eines dritten Kondensators sprechen erneut mindestens drei der Grenzwertmelder 22 und der Grenzwertmelder 38 an. Am Mittelpunktsinstrument 41 kann abgelesen werden, in welcher Batteriehälfte die Kondensatoren ausgefallen sind. Falls mehr als drei Kondensatoren in einer Batteriehälfte ausfallen, spricht zusätzlich auch der Grenzwertmelder 43 an, der den Unsymmetriegrad überwacht.

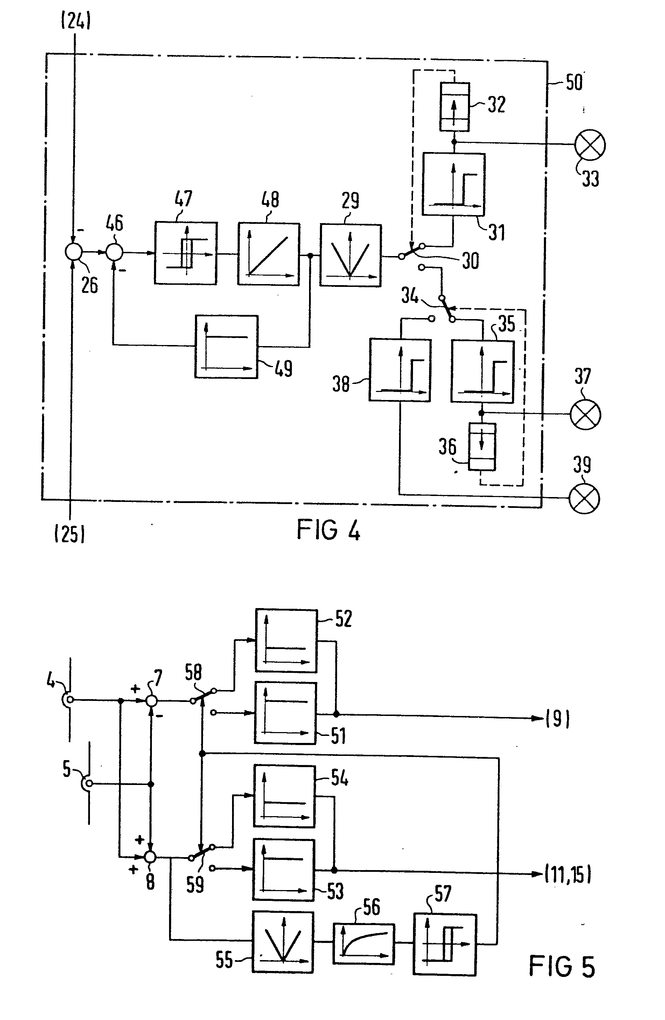

Fig. 4 zeigt ein weiteres Ausführungsbeispiel einer Auswerteeinrichtung 50, die anstelle der Auswerteeinrichtung 27 in Fig. 1 eingesetzt werden kann. Eingangsseitig werden dem Vergleicher 26 wiederum das Summensignal der Zeitstufen 23a

... 23n vom Summierglied 25 mit positivem Vorzeichen und das Summensignal der Grenzwertmelder 22a ... 22n vom Summierglied 24 mit negativem Vorzeichen zugeführt. Das Ausgangssignal des Vergleichers 26 wird über einen weiteren Vergleicher 46 auf einen Trigger 47 gegeben, der sein Ausgangssignal beim Wechsel der Polarität seiner Eingangsspannung ändert. Der Ausgang des Triggers 47 ist mit dem Eingang eines Integrators 48 verbunden, dessen Ausgangsspannung über einen Proportionalverstärker 49 auf den Vergleicher 46 rückgekoppelt ist. Die Ausgangsspannung des Integrators 48 wird weiterhin der Gleichrichterschaltung 29 zugeführt, in deren Ausgang der Umschalter 30 liegt. Die weitere Signalverarbeitung erfolgt wie bei der in Fig. 2 dargestellten Auswerteeinrichtung 27.

Die Auswerteeinrichtung 50 führt zu konstanten Auslösezeiten. Dies ist wichtig, wenn bei Leitungskurzschlüssen infolge unterschiedlicher Sättigungen der Stromwandler 4 und 5 kurzzeitig sehr hohe Differenzströme angezeigt werden, die jedoch nicht zu einer Fehlanzeige führen sollen.

Fig. 5 zeigt eine Eingangsschaltung mit einer automatischen Bereichsumschaltung, die bei der in Fig. 1 dargestellten Überwachungseinrichtung vorteilhaft eingesetzt werden kann, wenn sich der Kondensatorstrom in einem sehr weiten Bereich ändert. In den beiden Kanälen zur Verarbeitung der den Differenzstrom bzw. den Summenstrom abbildenden Meßspannungen sind jeweils über Verstärkerschaltungen mit veränderbarem Verstärkungsfaktor geführt. Die Verstärkerschaltung für die den Differenzstrom abbildende Meßspannung besteht aus zwei ausgangsseitig miteinander verbundenen Proportionalverstärkern 51 und 52 mit unterschiedlichen Verstärkungsfaktoren, deren Eingänge über einen Umschalter 58 mit dem Ausgang des Vergleichsgliedes 7 (vergleiche fig. 1) verbunden sind. Die Verstärkerschaltung für den Summenstrom besteht aus den beiden ausgangsseitig verbundenen Proportionalverstärkern 53 und 54 mit unterschiedlichen Verstärkungsfaktoren, die eingangsseitig über einen Umschalter 56 mit dem Ausgang des Summiergliedes 8 verbunden sind. Die Verstärkungsfaktoren der Proportionalverstärker 51 und 53 sind gleich. Die Verstärkungsfaktoren der Proportionalverstärker 52 und 54 sind ebenfalls gleich. Die Ansteuerung der Umschalter 58 und 59 erfolgt in Abhängigkeit vom Summenstrom. Die den Summenstrom abbildende Ausgangsspannung des Summiergliedes 8 wird in einer Gleichrichterschaltung 55 gleichgerichtet und von einem nachgeschalteten Tiefpaßfilter 56 von 1. Ordnung in eine amplitudenproportionale Gleichspannung umgeformt. Diese Gleichspannung wird auf einen Grenzwertmelder 57 gegeben, dessen Ausgangssignal die Umschalter 58 und 59 steuert. Die Umschalter 58 und 59 werden beim Überschreiten bzw. Unterschreiten eines vorgegebenen Ansprechschwellenwertes derart umgesteuert, daß bei kleinem Summenstrom die Proportionalverstärker mit dem größeren Verstärkungsfaktor in beiden Kanälen wirksam sind und daß bei großem Summenstrom die Proportionalverstärker mit dem kleineren Verstärkungsfaktor in beiden Kanälen wirksam sind.

Eine andere Möglichkeit zur Erzielung umschaltbarer Verstärkungen in beiden Kanälen besteht in der Verwendung von Proportionalverstärkern, deren Rückkopplungsnetzwerk aus der Parallelschaltung eines ersten ohmschen Widerstandes mit einer Reihenschaltung eines zweiten ohmschen Widerstandes und eines elektronischen Schalters besteht. Ist der Schalter, insbesondere ein Schalttransistor, stromdurchlässig gesteuert, so ist als Rückkopplungswiderstand die Parallelschaltung der beiden ohmschen Widerstände wirksam und bestimmt im Verhältnis zum Eingangswiderstand den Verstärkungsfaktor. Ist der Schalter gesperrt gesteuert, so ist als Rückkopplungswiderstand nur der erste ohmsche Widerstand wirksam und bestimmt im Verhältnis zum Eingangswiderstand einen entsprechend geänderten Verstärkungsfaktor. Die gleichzeitige Ansteuerung der Schalter in den Rückkopplungsnetzwerken erfolgt wiederum in Abhängigkeit von der Amplitude des Summenstromes.

## Ansprüche

1. Überwachungseinrichtung für die Kondensatorbatterie eines Gleichstrom-Filterkreises, die aus wenigstens zwei gleich aufgebauten parallelen Strängen mit jeweils einer Anzahl von in Reihe geschalteten Kondensatoren besteht, wobei aus den Sekundärspannungen von in den Strängen angeordneten Stromwandlern eine der Differenz der Strangströme entsprechende Größe gebildet wird, gekennzeichnet durch folgende Merkmale :

a) Die Summe und die Differenz der Stromwandler-Sekundärspannungen in jeweils zwei gleich aufgebauten Strängen wird mittels je einer Gleichrichterschaltung (15, 17) und einem dieser nachgeordneten Tiefpaßfilter (16, 18) in zwei Gleichspannungen umgeformt, deren Amplituden der Differenz bzw. der Summe der Oberschwingungsströme in den beiden Strängen proportional sind ;

b) mittels Vergleichsgliedern (21a ... 21n) wird die Differenzspannung zwischen der dem Oberschwingungs-Differenzstrom proportionalen Gleichspannung und einem jeweils dem einzelnen Vergleichsglied zugeordneten Bruchteil der dem Oberschwingungs-Summenstrom proportionalen Gleichspannung gebildet und diese Differenzspannungen werden jeweils einem Grenzwertmelder (22a ... 22n) zugeführt, dem jeweils ein Zeitglied (23a ... 23n) mit Ansprechverzögerung nachgeschaltet ist ;

c) die Ausgangssignale der Vergleichsglieder (21a ... 21n) und die Ausgangssignale der Zeitglieder (23a ... 23n) werden jeweils den Eingängen von Summiergliedern (24, 25) zugeführt, deren Ausgangssignale mit den Eingängen eines im Eingang einer Auswertestufe (27) angeordneten Vergleichsgliedes (26) verbunden sind, welches die Differenz zwischen den Ausgangssignalen der Summierglieder (24, 25) bildet.

2. Überwachungseinrichtung nach Anspruch 1, dadurch gekennzeichnet, daß für die der Differenz der Oberschwingungsströme proportionale Gleichspannung eine Driftkompensation mit folgenden Merkmalen vorgesehen ist:

a) Die Differenz der beiden Stromwandler-Sekundärspannungen wird zusammen mit einer Korrekturspannung über ein Mischglied (9) der Gleichrichterschaltung (17) zugeführt;

b) die Korrekturspannung wird von einem Multiplizierer (14) gebildet, dessen Eingänge mit der Summe der beiden Stromwandler-Sekundärspannungen und dem Ausgangssignal eines integralen Reglers (13) beaufschlagt sind;

c) dem integralen Regler (13) ist ein weiterer Multiplizierer (11) vorgeschaltet, dessen Eingänge mit der Summe der beiden Stromwandler-Sekundärspannungen und der invertierten Ausgangsspannung des Mischgliedes (9) beaufschlagt sind.

3. Überwachungseinrichtung nach Anspruch 1, dadurch gekennzeichnet, daß Summe und Differenz der beiden Stromwandler-Sekundärspannungen jeweils über eine Verstärkerschaltung (51, 52, 58 bzw. 53, 54, 59) mit veränderbarem Verstärkungsfaktor geführt wird, der in Abhängigkeit der Summe der beiden Stromwandler-Sekundärspannungen veränderbar ist (Fig. 5).

**Claims**

1. A monitoring device for the capacitor block of a d. c. filter circuit which consists of at least two parallel lines of identical construction, each comprising a number of series connected capacitors, where a value corresponding to the difference between the line currents is formed from the secondary voltages of current transformers arranged in the lines, characterised by the following features:

a) both the sum of and the difference between the current transformer-secondary voltages in every two lines of identical construction are converted by respective rectifier circuits (15, 17), each with a following low-pass filter (16, 18), into two d. c. voltages whose amplitudes are proportional to the difference between and the sum of the harmonic currents in the two lines;

b) with the aid of comparison elements (21a ... 21n) the difference voltage is formed between the d. c. voltage which is proportional to the harmonic difference current and a fraction of the d. c. voltage which is proportional to the harmonic sum current assigned to the individual comparison element in question, and these difference voltages are each fed to a limit value indicator (22a ... 22n) each of which is followed by a time element (23a ... 23n) featuring delayed response;

c) the output signals from the comparison elements (21a ... 21n) and the output signals from the time elements (23a ... 23n) are fed to the inputs of adders (24, 25) whose output signals are fed to the inputs of a comparison element (26) which is arranged in the input of an analysis stage (27) and which forms the difference between the output signals from the adders (24, 25).

2. A monitoring device as claimed in Claim 1, characterised in that a drift compensation is provided for the d. c. voltage which is proportional to the difference between the harmonic currents, comprising the following features:

a) the difference between the two current transformer secondary voltages is fed via a mixer (9) to the rectifier circuit (17) together with a correction voltage;

b) the correction voltage is formed by a multiplier (14) whose inputs are fed with the sum of the two current transformer secondary voltages and the output signal of an integral regulator (13);

c) the integral regulator (13) is preceded by a further multiplier (11) whose inputs are fed with the sum of the two current transformer secondary voltages and the inverted output voltage of the mixer (9).

3. A monitoring device as claimed in Claim 1, characterised in that the sum of and the difference between the two current transformer secondary voltages are each fed via a respective amplifier circuit (51, 52, 58 and 53, 54, 59) possessing a variable amplification factor which can be varied in dependence upon the sum of the two current transformer secondary voltages (Fig. 5).

**Revendications**

1. Dispositif de surveillance pour la batterie de condensateurs d'un circuit de filtrage en courant continu, qui est constitué par au moins deux branches parallèles de même constitution et ayant chacune un certain nombre de condensateurs montés en série, du type dans lequel on forme, à partir des tensions secondaires de transformateurs d'intensité disposés dans les branches, une grandeur qui correspond à la différence des courants dans les branches, remarquable par les caractéristiques suivantes:

a) la somme et la différence des tensions secondaires des transformateurs d'intensité dans respectivement deux branches de même constitution sont transformées, à l'aide d'un circuit redresseur respectif (15, 17) et d'un filtre passe-bas (16, 18) monté en aval de ce dernier, en deux tensions continues dont les amplitudes sont proportionnelles à la différence ou à la somme des courants harmoniques dans les deux branches;

b) à l'aide de comparateurs (21a ... 21n) on forme la tension différentielle entre la tension continue proportionnelle au courant différentiel d'harmonique et une fraction de la tension continue proportionnelle au courant de somme d'harmonique, qui est associée respectivement au comparateur individuel, et ces tensions différentielles sont respectivement appliquées à un dispositif de signalisation de valeur limite (22a ... 22n) auquel est branché en aval un temporisateur (23a ... 23n) à déclenchement retardé ;

c) les signaux de sortie des comparateurs (21a ... 21n) et les signaux de sortie des temporisateurs (23a ... 23n) sont respectivement appliqués aux entrées de totalisateurs (24, 25) dont les signaux de sortie sont reliés aux entrées d'un comparateur (26) qui est disposé dans l'entrée d'un étage d'évaluation (27) et qui forme la différence entre les signaux de sortie des totalisateurs (24, 25).

2. Dispositif de surveillance selon la revendication 1, caractérisé par le fait que pour la tension continue proportionnelle à la différence des courants harmoniques, il est prévu une compensation de dérive ayant les particularités suivantes :

a) la différence des deux tensions secondaires des transformateurs d'intensité est appliquée, avec une tension de correction et par l'intermédiaire d'un mélangeur (9), à un circuit redresseur (17) ;

b) la tension de correction est formée par un multiplicateur (14) dont les entrées reçoivent la somme des deux tensions secondaires des transformateurs d'intensité et le signal de sortie d'un régulateur intégral (13) ;

c) en amont du régulateur intégral est monté un second multiplicateur (11) dont les entrées reçoivent la somme des deux tensions secondaires des transformateurs d'intensité et la tension de sortie inversée du mélangeur (9).

3. Dispositif de surveillance selon la revendication 1, caractérisé par le fait que la somme et la différence des deux tensions secondaires des transformateurs d'intensité sont respectivement contrôlées par l'intermédiaire d'un circuit amplificateur (51, 52, 58 et 53, 54, 59) à facteur d'amplification variable, qui est susceptible d'être modifié en fonction de la somme des deux tensions secondaires des transformateurs d'intensité.

FIG 1

FIG 2

FIG 3

FIG 4

FIG 5